# EUROPEAN PATENT SPECIFICATION

(11) **EP 0 567 748 B1**
(45) Date of publication and mention of the grant of the patent: **26.11.1997**
(21) Application number: 93104070.3
(22) Date of filing: 12.03.1993
(51) Int. Cl.: G11B 5/64, H01L 21/3205

(54) **Fabrication of rough silicon surfaces**
Herstellung von rauhen Silizium-Oberflächen
Fabrication de surfaces rugueuses en silicium

(30) Priority: 10.04.1992 US 866713
(43) Date of publication of application: 03.11.1993
(73) Proprietor: International Business Machines Corporation, Armonk, N.Y. 10504 (US)
(72) Inventor: Dana, Stephane Simon, Weizmann Inst. of Science, Rehovot (IL); Anderle, Mariano, I-38060 Mattarello (IT); Rubloff, Gary Wayne, Waccubuc, New York 10597 (US); Schrott, Alejandro Gabriel, New York, New York 10011 (US); Liehr, Michael, Yorktown Heights, New York 10598 (US)
(74) Representative: Rach, Werner, Dr.

(56) References cited:
- DE-A- 3 543 254
- US-A- 5 091 225
- US-A- 5 102 832
- US-A- 5 112 773
- PATENT ABSTRACTS OF JAPAN vol. 16, no. 14 (E-1154)14 January 1992
- JAPANESE JOURNAL OF APPLIED PHYSICS vol. 29, no. 12, December 1990, TOKYO JP pages 2345 - 2348 Y. HAYASHIDE ET AL. 'Fabrication of Storage Capacitance- Enhanced Capacitors with a Rough Electrode'
- PATENT ABSTRACTS OF JAPAN vol. 15, no. 405 (E-1122)16 October 1991
- PATENT ABSTRACTS OF JAPAN vol. 16, no. 73 (E-1169)21 February 1992
- PATENT ABSTRACTS OF JAPAN vol. 16, no. 246 (E-1212)5 June 1992
- PATENT ABSTRACTS OF JAPAN vol. 12, no. 412 (E-676)31 October 1988

## Description

### Field of the Invention

The present invention relates to the fabrication of semiconductor materials, and more particularly to a system and method for producing rough silicon surfaces with a precise level of control that renders them adaptable to wide application in computer-related devices, such as in VLSI chips and magnetic disks.

### Prior Art

In semiconductor technology as the device dimensions are getting smaller it is becoming increasingly critical to be able to manipulate the surface topology of a substrate with control in the nanometer range. Although this is possible in principle using state-of-the-art lithography techniques, these techniques are difficult to exploit in practice. In addition to the problems of photoresist handling, focus and depth-of-field, and proximity effects, nanolithography approaches suffer from low throughput, making them highly problematic for manufacturing applications.

A number of possible applications can be contemplated in which surface morphology may be tailored to advantage within the spatial regime of conventional and advanced lithography. In these cases, surface textures might be fabricated with some degree of randomness in their location. By exploiting such possibilities enhanced functionality for microelectronics applications can be gained. Three examples illustrate these possibilities.

A first example is the use of rough Si surface morphology, on the scale of ≤100nm feature sizes, to enhance capacitance density for capacitor applications like DRAM. The problem is that high levels of DRAM integration (e.g., 256 Mb or 1 Gb chips) necessitate smaller areas to hold each bit of information, but these smaller areas must provide higher capacitance per unit area. Recent publications, such as, H. WATANABE, N. AOTO, S. ADACHI, T. ISHIJIMA, E. IKAWA, AND K. TERADA, "New stacked capacitor structure using hemispherical-grain polycrystalline-silicon electrodes", Appl. Phys. Lett. 58 (3), 251 (1991). (NEC Corp), M. SAKAO, N. KASAI, T. ISHIJIMA, E. IKAWA, H. WATANABE, K. TERADA, AND T. KIKKAWA, "A capacitor-over-bit-line (COB) cell with a hemispherical-grain storage node for 64Mb DRAMs", IEDM 90-655, 27.3.1 (1990). (NEC Corp), and M. YOSHIMARU, J. MIYANO, N. INOUE, A. SAKAMOTO, S. YOU, H. TAMURA, AND M. INO, "Rugged surface poly-Si electrode and low temperature deposited &Si3N4. for 64 Mbit and beyond STC DRAM cell", IEDM 90-659, 27.4.1 (1990). (OKI Corp), disclose results on the growth of rough polySi surfaces that show effective area enhancement (∼2.5X) for given capacitor area, since within a given macroscopic area the rough surface texture provides more actual surface area. Rough surface texture is attractive when compared to its alternatives, namely (i) thinner insulator layers (which suffer from tunneling currents as well as much more difficult defect density considerations) and (ii) insulators of higher dielectric constant (which require fundamentally new materials and processes). On the other hand, a major concern is that the temperature window for growth of polySi with rough surface morphology has in prior art been very limited, extending only over ∼10°C. Such tight temperature control is a problematical constraint on manufacturability. The explanation for the cause of rough surface morphology has been the occurrence of growth temperatures at the boundary between the amorphous and polySi microstructures. If this explanation is correct, a broader temperature process window using this mechanism would be unlikely. However, manufacturability concerns make it essential to develop processes with considerably broader temperature windows.

A second example, in a comparatively remote application, is the use of rough Si surfaces for the fabrication of low-stiction magnetic disk surfaces for storage applications. In order to minimize mechanical friction - especially at starting - disk surfaces are normally roughened before deposition of the magnetically active thin film, but the physical techniques presently used involve metallic substrates, which suffer from problems of topographic control as well as gouging and corrosion. New approaches which provided better control over morphology and its reproducibility, especially on a nanometer scale, would be of real benefit.

A third example is the exploitation of quantum effects in nanometer Si wires or dots which then permit significant light emission to occur in Si structures. See, for example, L.T. CANHAM, "Silicon quantum wire array fabrication by electrochemical and chemical dissolution of wafers", Appl. Phys. Lett. 57 (10), 1047 (1990).

The common theme in these three somewhat disparate examples is the desirability of a method for fabricating Si surfaces of controlled, predictable morphology with roughness length scales in the nanometer regime. Such rough Si surfaces would in all three cases be of real benefit when incorporated into larger, lithographically-defined microelectronic structures. Since the benefits of these rough Si applications do not require precise control of where the features (e.g., peaks or valleys in the topography) are found within lithographic dimensions, significant elements of statistical randomness can be accommodated. This factor opens the door to a new range of chemical and physical processes and structures. The manufacturability of such structures would require not only high reproducibility but also good control over the density and shape of rough nanoscale features, irrespective of actually where they appeared on the surface. It should be clear that conventional lithography (e.g., electron beam) would require impossibly long exposure time to write similar features.

US-A-5 102 832 discloses a process for texturization of polycrystalline silicon comprising the steps of preparing the wafer surface prior to poly deposition with a material which will cause the poly to preferentially nucleate during deposition and form poly nodules on the wafer surface. Polysilicon will continue to coat the previously created poly nodules throughout poly deposition, thereby resulting in a stable, texturized polysilicon structure. US-A-5 102 832 does not disclose how to regulate or control the temperature and the pressure of the deposition step.

Japanese Journal of Applied Physics 29 (1990) December, No. 12, Part 2, pages L2345 to L2348 describes the Fabrication of Storage Capacitance-Enhanced Capacitors with a Rough Electrode. Polysilicon films were deposited on thermally grown SiO₂ by the LPCVD method using both SiH₄ and N₂ at deposition temperature, T_{d}, ranging from 540°C to 640°C. The partial pressure of SiH₄ was approximately 0,2 Torr (26.7 Pa). The film deposited at 600°C shows a relatively smooth surface. Approximately 40-nm-high domelike bumps, whose density and diameter increase with the deposition temperature, are observed on the film surface deposited at 560°C. Polysilicon film deposited at 580 °C shows quite a rough surface consisting of about 100 nm high bumps. This phenomenon was also observed in the case of the polysilicon film deposited on SiO₂ films, Si₃N₄ films prepared by the LPCVD method and silicon substrates. No remarkable change of the surface asperity was observed when the polysilicon film was doped or annealed.

Plasma processes are capable of forming particles in the gas phase, and this has been suggested - together with directional etching for pattern transfer - as a means to generate random nanostructures on a surface. For instance, see G. S. SELWYN, G. S. OEHRLEIN, AND Z. A. WEINBERG, "Controlled surface texturing of materials", IBM TDB Vol.34, No.5, pps. 381-2, October, 1991. However, this approach yields a particle size distribution which is fairly broad, leading to a similar distribution of nanostructure sizes on the surface.

It is therefore the object of the present invention and highly desirable to provide an alternate, non-lithographic approach using a deposition or etching system to fabricate surface textures with random, nanometer-scale roughness. While the location of individual features (e.g., peaks) can be random, it is also highly desirable to control such parameters of these features as their density, their local shape, and their average size.

These objects are basically solved in advantageous manner by applying the features as laid down in the independent claims.Further advantageous developments are contained in the related subclaims.

The present invention involves the fabrication of Si surfaces with rough morphology on a nanometer scale using deposition (and in some cases etch) processes which control the roughness density, roughness length scale, and morphology. Further, the existence of the rough morphology does not depend critically on the process temperature, thereby offering a process which is much more readily utilizable in manufacturing than prior art processes for this purpose.

In accordance with the invention, a method is provided for fabricating a rough Si surface texture by using 1) a low pressure chemical vapor deposition (CVD) process, i.e., typically at a pressure in the 1 to 5 mTorr (0.13 - 0.67 Pa) range, and broadly in the range from about 0.1 to 100 mTorr (0.013 - 13.3 Pa), and/or 2) initial surface conditions such that initial growth is nucleation-controlled, e.g., using a thermal SiO₂ surface which is relatively unreactive to SiH₄ at an operating temperature below about 700°C permitting operating temperatures in an expanded range of ≥100°C. The low pressure is believed to prevent excessive deposition of small gas-phase-nucleated particles, which would cause a smooth surface rather than the roughness desired. The broad temperature window obtained contrasts with the narrow, less than 10° window permitted by prior art processes.

Further, the invention involves various methods for achieving surface pretreatment to control the size and density of the initial nuclei preparatory to the performance of the foregoing fabrication process.

In addition, the invention includes a method to produce on a substrate surface, directly and in-situ, a pattern of submicrometer sized dots such that the dot center surface density and the total dot surface area coverage can be precisely controlled, using the features of the above-described process with additional steps to achieve the desired dots.

Finally, particular applications of the system and method as suggested above include fabricating rough Si surfaces as (1) electrodes for high capacitance density structures for high density DRAM and (2) as substrates for low-stiction magnetic disks. In both cases, the rough Si surfaces are prepared by (a) choosing or fabricating a surface which is chemically inert with respect to silane exposure at operating temperatures broadly in the range from about 450°C to about 700°C, and typically in the range of 500 - 600°C, so that growth will be dominated by nucleation at specific defect sites, and (b) selectively growing Si on the distinct nucleation sites so as to enhance and transfer the morphology pattern of the nucleation sites into a thicker, rough Si film. Appropriate selection of deposition parameters, e.g., growth temperature, pressure, and initial surface condition, and of reactant species, SiO₂ and silane, provide preferred embodiments of the inert initial surface and reactant, respectively.

### BRIEF DESCRIPTION OF THE DRAWINGS

Figures 1(a) through 1(d) are sectional views of a substrate surface illustrating a process sequence for the formation of a planar capacitor structure with high capacitance density fabricated in accordance with the present invention.

Figure 2 is a sectional view of a low-stiction surface on a magnetic disk having a rough silicon layer produced in accordance with the present invention disposed between the substrate and the magnetic surface layer with the rough silicon in the form of a series of random Si islands.

Figure 3 is a sectional view of a low-stiction surface on a magnetic disk having a rough silicon layer produced in accordance with the present invention wherein the rough silicon layer completely covers the substrate surface.

Figure 4 is a plot illustrating the growth in time of Si nuclei, produced in accordance with the present invention, as a function of temperature at a pressure of 1.6 mTorr (0.21 Pa), and showing clearly that the surface area coverage by Si dots can be controlled by these parameters.

Figures 5(a) through 5(d) are sectional views of a substrate surface illustrating a process sequence for the formation of Si quantum dots for light emitting structures in accordance with the invention.

Figure 6 is a plot of surface area coverage by grown nuclei in accordance with the invention as a function of deposition time at a temperature of 550 °C for deposition pressures of 1.6 and 3.2 mTorr (0.21 - 0.43 Pa).

### DETAILED DESCRIPTION OF THE EMBODIMENTS

The present invention involves systems and methods by which the temperature process window for the growth of rough Si surface textures is expanded to ≥100°C, as compared to prior processes wherein the process window was limited to less than 10°C. The key factors in achieving a significantly broader process window are: (1) the use of very low pressure CVD conditions in the regime of about 0.1 to 100 mTorr (0.013 Pa - 13.3 Pa), as contrasted with conventional LPCVD at ≥200 mTorr (26.7 Pa); and/or (2) initial surface conditions which favor nucleation-controlled growth. The ability to achieve this much larger process window greatly enhances the feasibility of manufacturing rough silicon surfaces with broad applications.

More particularly, previous work to grow rough polySi films was carried out under fairly standard LPCVD SiH₄ growth conditions, i.e. ≥200 mTorr (26.7 Pa), in a standard hot-wall LPCVD reactor. The present invention achieves a substantially broader temperature window (≥100°C) for rough Si growth by employing a very different approach. First, very low pressure conditions are used, e.g., ∼1 mTorr (0.13 Pa) undiluted SiH₄. Such a pressure regime is inaccessible with conventional LPCVD tools and processes and thus normally would not be contemplated by those skilled in the art of polysilicon deposition using standard LPCVD conditions. The low pressure is believed to be important in order to minimize gas phase reaction, which could lead to deposition of very small particles and hence smoothing rather than roughening of the growth surface. Second, additionally or alternatively, the initial surface condition is chosen so that initial growth is nucleation-controlled, e.g., using a thermal SiO₂ surface which is relatively unreactive to SiH₄ in this temperature regime. Heretofore, initial nucleation has not been identified as an important factor in the growth of rough Si surfaces. Nucleation at the initial stages of growth is important in that it ultimately determines the topography of the rough Si films.

The two factors noted suggest that the growth of rough Si surfaces should involve basically two stages:

### · Generation of initial nuclei.

Initial nuclei growth should be low density. By using surface conditions which cause nucleation-controlled initial growth, a low density (∼10¹⁰/cm²) of Si nuclei can be formed on the surface. This is, for example, the case for the SiH₄ reaction on thermal SiO₂ in the temperature range ∼500-600°C. The use of very low pressures, in the range ∼1 mTorr (0.13 Pa), prevents gas phase reaction and particle formation, so that higher densities of Si nuclei are not deposited on the surface.

It is believed that the use of very low pressures is important in preventing excessive deposition of gas-phase-nucleated particles on the surface, since large numbers of microparticles would form a fairly smooth surface as commonly obtained in conventional LPCVD polySi (except for very special, narrow temperature regimes). Here, a relatively low density of nuclei is established (∼10¹⁰/cm²) to form a roughness template; and, once the surface is sufficiently covered, the growth is dominated by size increase in the Si nuclei, which largely replicates the roughness of the inital template.

Because nucleation and subsequent very low pressure growth can both occur and be controlled over a broad temperature range, it is possible to obtain a substantial (∼100°C) temperature process window for rough Si growth. In contrast, previous work has involved the production of rough Si only over a much narrower temperature window corresponding to the amorphous/polycrystalline transition temperature - a very different growth mechanism.

As described below, reasonable initial nuclei densities (∼10¹⁰/cm²) are obtained using thermal SiO₂ surfaces, and a number of other approaches to establishing useful initial nuclei densities can be envisioned, such as a more highly defective oxide layer like native oxide, or impurity dosing (oxygen, carbon, etc.). Furthermore, it has been found that the roughness length scale (or initial nuclei density) can be varied significantly by variations in temperature and in pressure or residence time of reactant species in the reactor. This leads to tradeoffs which optimize microstructure/topography against growth rate, etc.

### · Growth of rough Si film from initial nuclei.

Once Si nuclei are present on the surface, the selectivity of SiH₄ growth plays a key role. The SiH₄ reaction on Si is much faster than on SiO₂, so that once sufficient Si surface area has been established by the deposited nuclei, most subsequent Si deposition will take place on the nuclei and cause the surface morphology of the film to replicate the pattern of initial nuclei. Because very low pressures are used, gas phase nucleation and particle generation do not contribute significantly to film growth and morphology. In effect, then, the growth of Si from the original nuclei established represents a pattern transfer from a two-dimensional array of nuclei to a rough topography of the final Si film.

While adequate results for some purposes may be obtained using either of the two noted factors alone, experimental results and observations do suggest that rough Si surfaces could not be obtained over a broad growth temperature regime if higher pressures are used. At higher pressures, gas phase nucleation produces large densities of Si nuclei (microparticles) on the surface, leading to smoother morphology (much smaller grains at much higher density). Consequently, it is important to assure a low initial nuclei density and its morphological replication in the grown film.

Although Si surface mobility above the amorphous/crystalline transition temperature will change surface morphology somewhat (e.g., lead to faceting), the strong difference in reaction probability for SiH₄ on Si vs. SiO₂ assures that rough Si surfaces result over a broad growth temperature range.

In any event, it is highly desirable to attain independent control of the initial nuclei density irrespective of the growth conditions used to determine final nuclei sizes. To this end, improved control of the nuclei sites and density in the first step of surface fabrication may be achieved as follows.

### Surface fabrication

In a first embodiment, surface treatments may be used to determine the density of sites for nucleation. Such treatments may be effective in enhancing nucleation from the very low pressure growth process at those sites, by:
(i) deposition of impurities (carbon, metal, oxygen, etc.) from gas phase exposure (e.g., acetylene for carbon deposition), liquid exposure (dips), or physical vapor deposition (e.g., evaporation or sputtering);
(ii) creation of defects by ion implantation, x-ray radiation, ion etching/bombardment, UV light to break surface bonds, etc.;
(iii) chemical modification of the surface, e.g., by growth of incomplete or defective layers like oxide, use of different growth techniques for these layers, etc.; and
(iv) growth of a full surface layer, such as native oxide, thermal oxide, CVD nitride, plasma-enhanced CVD (PECVD) dielectric, etc.
All such treatments will offer different site densities for nucleation.

In an alternate embodiment, actual nuclei may be deposited on the surface rather than altering the surface to form favorable sites for nucleation. For instance, elevating the pressure and/or temperature for a brief time (cf., the steady-state nuclei growth condition) may be used to form microparticles or higher precursor species in the gas phase, which then deposit onto the surface as real nuclei. Following this "seeding" of the surface, these initial nuclei at controlled densities may be subjected to further growth by very low presssure CVD.

In view of the foregoing control of the formation of initial nuclei density, growth may be limited to specific regions of the surface (e.g., ion implantation with a mask present) at least in some cases, leading to the possibility of patterning the resulting rough Si topographic regions.

In an actual implementation rough Si surfaces were produced by the SiH₄ CVD growth of Si films ∼100nm thick in an ultraclean (UHV base pressure), cold-wall, rapid thermal CVD (RTCVD) reactor at pressures in the range ∼1 mTorr (0.13 Pa), where gas phase nucleation should be small (see B.MEYERSON, J.JASINSKI, J. Appl. Phys. vol.61, p.785 (1987)). Deposition was initiated on thermal SiO₂ films ∼20nm thick, leading to small densities of nucleation centers (∼10¹°/cm²). More details are described below in the section entitled *Nanometer-size Si dots*.

Scanning electron microscope (SEM) micrographs of the resulting surfaces were made and showed profound roughness for growth temperatures ranging from 510 to 570°C. This temperature range is ≥6X broader than that previously achieved for growth of rough polySi at the boundary between amorphous and polycrystalline Si growth. With higher growth temperature, there is increasing evidence of facets on the polySi "bumps" demonstrating that roughness has been produced rather independently of surface diffusion associated with Si grain growth. This is a clear indication that the roughness mechanism employed here is not the amorphous-crystalline transition discussed in the prior art.

Preliminary observations have also been made at other temperatures, e.g., ∼480°C and ∼600°C, and have found quite similar rough morphology of the Si film, suggesting that the temperature window for rough Si growth is ≥100°C, typically from about 500 to 600°C, and anywhere in the range from about 450 to 700°C.

Cross-sectional SEM micrographs suggest strongly that the rough surface morphology in the present invention results from additive pattern transfer due to growth at initial nucleation sites on the SiO₂ substrate surface.

Examples of applications in which specific embodiments of the invention may be used to advantage will now be described.

### High-capacitance density DRAM structures

By growing a rough Si thin film as described above, a controlled increase in effective available surface area may be achieved. Use of this surface as the bottom electrode in a capacitor structure, will increase the capacitance for given macroscopic capacitor area. The invention may thus be applied in chip manufacturing in the DRAM and/or optoelectronics areas. Alternative solutions, such as plasma particulate generation for micromasking, offer less flexibility because dot density and size are linked by a single process (e.g., gas phase particle formation).

When applied in environments where DRAM or related device structures are required, the approach is particularly valuable to achieve manufacturability at very high integration levels (e.g., 256 Mb or 1 Gb) due to the process control and latitude available. For example, the above-mentioned ability to control nuclei density and to tailor the shape of nuclei (e.g., faceting) offers the potential to realize high capacitance enhancement with small nuclei of high density (very fine grain roughness) and aspect ratio. With a large number of nuclei in each capacitance cell, the distribution of capacitance values will be narrower, permitting higher yield at high integration levels.

It is important to note that current DRAM designs employ either stacked or trench capacitor configurations, in which much of the capacitor surface is in fact vertical. Since the oxidation and rough Si CVD deposition processes are conformal, i.e., involve reaction at sidewalls as well as on horizontal surfaces, fabrication of rough Si surfaces can be readily accomplished in the relevant geometries for advanced DRAM capacitor structures.

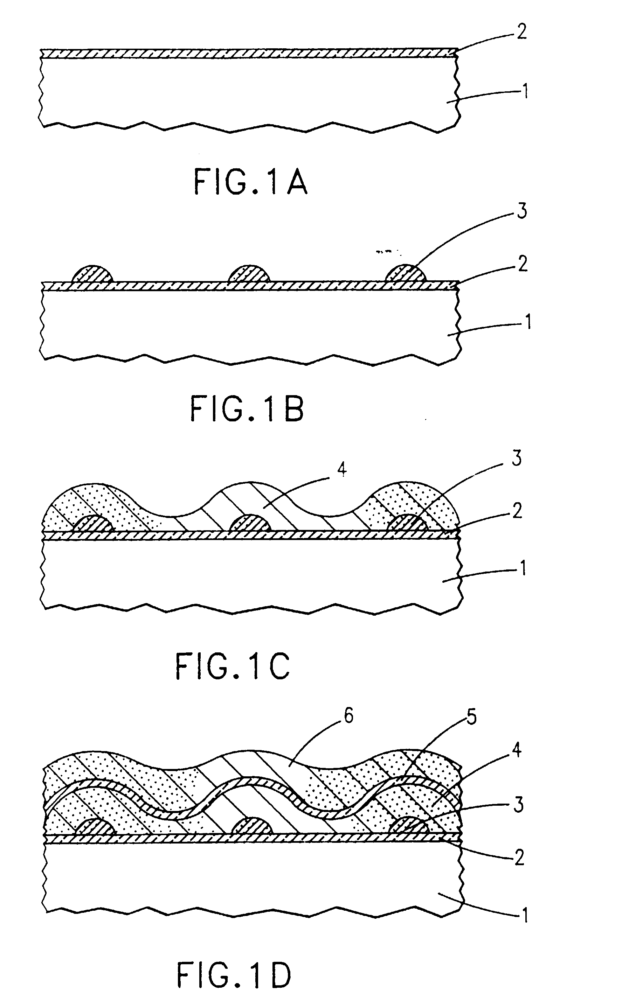

Accordingly, trench, stacked, or planar capacitor structures with high capacitance density may be fabricated by, referring to Figure 1(a), firstly treating the surface 2 of a substrate structure 1 so as to render it relatively inert with respect to reaction with Si-containing species, e.g., using a thermal SiO₂ layer thereon. Next, as shown in Figure 1(b), a Si-depositing-gas is used for depositing Si nuclei 3 on the surface 2. The density of the Si nuclei 3 formed on the substrate surface 2 is controlled by regulating the temperature and pressure conditions during deposition. It has been found that operating pressures can be below 200 mTorr (26.7 Pa) and may range broadly from about 0.1 mTorr to 100 mTorr (0.013 Pa - 13.3 Pa), with the preferred range being about 1 to 5 mTorr (0.13 Pa - 0.67 Pa). The operating temperature can be below about 700°C, and typically in the range of 500 - 600°C and as low as about 450°C.

As seen in Figure 1(c) further Si is then grown on the deposited nuclei 3 in order to produce a nearly continuous film 4 of Si with rough surface texture on the substrate structure. A thin conformal dielectric 5 is then formed over the rough Si surface of film 4, and finally, a Si top electrode 6 is deposited over the dielectric 5 to complete the capacitor structure as illustrated in Figure 1(d).

Hence, the invention is clearly applicable to DRAM technology and manufacturing, where enhanced capacitance density is a key driver. Other applications in high capacitance structures may include decoupling capacitors in high performance bipolar technology, or storage capacitors for thin film transistor liquid crystal display technology.

### Low-stiction magnetic disks

A particularly valuable application of the present invention is in connection with magnetic disk manufacturing. The disclosed techniques are suitable for use in fabricating a passive topographic surface of controlled roughness on a 100 nm length scale as a substrate for low-stiction thin magnetic disk surfaces.

The reliability of thin film magnetic disk technology is limited by stiction between head and disk at start-up. To reduce stiction, disk surfaces are normally roughened prior to the deposition of a magnetically active thin film. Known technologies for producing low-stiction surfaces suffer from at least two shortcomings. First, the roughness characteristics are difficult to control on a nanometer scale; and, second, roughness is currently generated by physical means (e.g., operating tape, similar to sandpaper), which are limited in application to metallic substrates. In such case, defect densities are high due to (i) the generation of excessively large asperities associated with gouging of ductile metals and (ii) corrosion associated with galvanic action. Advancement in low-stiction technology requires better control of the roughness characteristics and statistics as well as applicability to insulating, passive substrates (e.g., glass) where advantages of lower cost and higher reliability are expected.

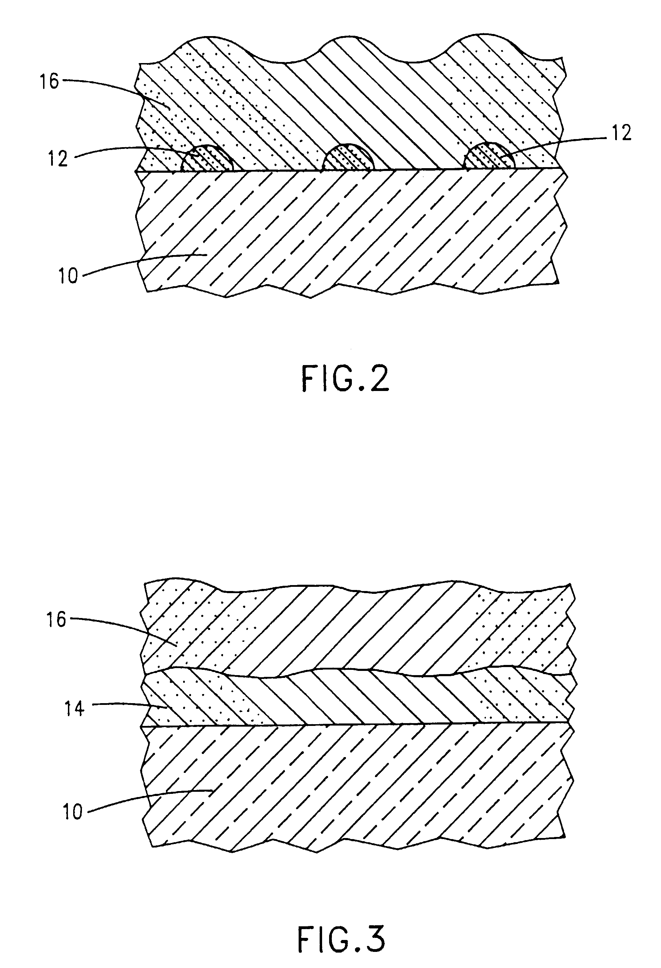

In accordance with the present invention, the formation of controlled roughness is based on the nucleation and early growth of Si islands by chemical vapor deposition. As desired, the surface of the substrate may be completely or incompletely covered by the depositied silicon. Two such configurations are illustrated schematically in Figures 2 and 3; the former showing incomplete coverage, and the latter showing complete coverage of the substrate surface. As seen in the Figures, a suitable disk substrate 10 is provided to receive the rough silicon to be deposited. The deposition may be controlled as described herein to produce a series of random Si islands 12 as in Figure 2 or a rough continuous surface 14 as in Figure 3. After the processes described herein to form such a rough Si surface are completed a conformal magnetically active layer 16 can be deposited to achieve the low-stiction disk surface desired. Si deposited on thermal SiO₂ at a temperature of ∼550°C at ∼2 mTorr (0.27 Pa) SiH₄ pressure displays morphology which can serve as a suitably roughened substrate for the conformal thin film magnetic layer of a disk. It should be noted that the roughness length scale in these cases is ∼100 nm, with aspect ratio ∼1, as presently required for low-stiction disk technology.

### Nanometer-size Si dots

It will be seen from the foregoing descriptions that nanometer-size Si dots may be formed from very low pressure Si CVD, e.g., ∼0.1 to 100 mTorr (0.013 Pa - 13.3 Pa), by a two-step sequence:
(1) generation of nuclei at desired density; and
(2) controlled growth to desired coverage (average dot size or diameter).
The pattern of dots can then be transferred into the substrate, e.g., by etching, for a variety of applications where nanometer-scale features are required.

It is a further feature of the present invention to separate the processes for defining dot density and dot size (or area coverage) and control each independently. The preferred embodiment in this regard employs very low pressure SiH₄ CVD for both steps in sequence within the same reactor. First, a desired density of nuclei is produced on the surface. Second, very low pressure CVD is used to enlarge these small nuclei to the desired size.

In the preferred embodiment, this sequence encompasses the following procedures:
· Beginning with a well-defined substrate surface (e.g., thermal SiO₂) and low defect density (few nucleation sites), a large density of nuclei is then generated on the surface. One way to achieve this is to generate very small particles (or precursor molecules like disilane) during silane CVD at elevated pressure, which then deposit as seed nuclei on the surface. A second approach would be to form nuclei on the surface by heterogeneous reaction and to control their size and density distribution through the deposition parameters (temperature, pressure). Within the second approach, other surface pretreatments (e.g., native oxide, ion bombardment, etc.) could be employed to vary the nucleation site density in a controlled way.
· Once the desired density of nuclei has been established on the surface, Si deposition from SiH₄ (or other reactants) is carried out (e.g., at very low pressure) to cause 3-dimensional growth of Si nanostructural features at the nucleation sites. If very low pressures are employed, generation of new nucleation sites will be negligible. Furthermore, if the initial nuclei are very small, the size distribution of grown Si dots will be sharp, and average dot size will be closely controlled by growth conditions (temperature, time, actual pressure, etc.).

After the desired Si dot density and area coverage have been obtained, directional plasma-based etching may be used to transfer the pattern into the surface, as described in the previously-cited IBM TDB of G. S. SELWYN ET AL, and below. It should be noted that the fabrication of these nanostructural features is accomplished in-situ, including definition and fabrication of features without resist processing.

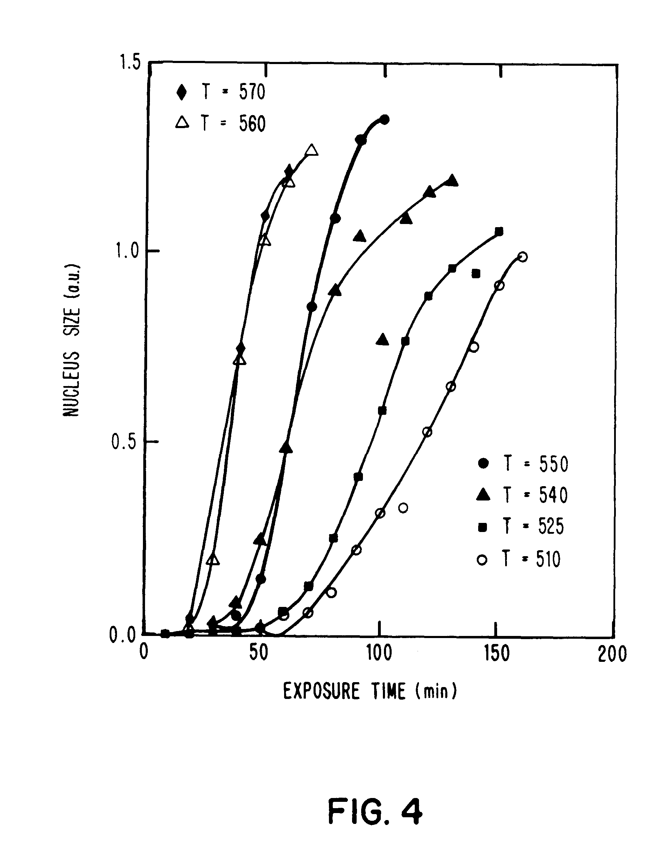

More specifically, the above SiH₄-based CVD embodiment has been used to grow a well-defined density of Si nuclei on a 20nm thermal SiO₂ layer using ultrahigh-vacuum-based rapid thermal CVD. Scanning electron microscope (SEM) micrographs of the resulting surfaces show profound roughness in the sample with isolated nuclei at ∼1/2 area coverage on the surface. Further, the growth of nuclei with time as a function of temperature, ranging from 510°C to 570°C, at a pressure of 1.6 mTorr (0.21 Pa) is depicted in Figure 4, which shows clearly that the surface area coverage by Si dots can be appropriately controlled.

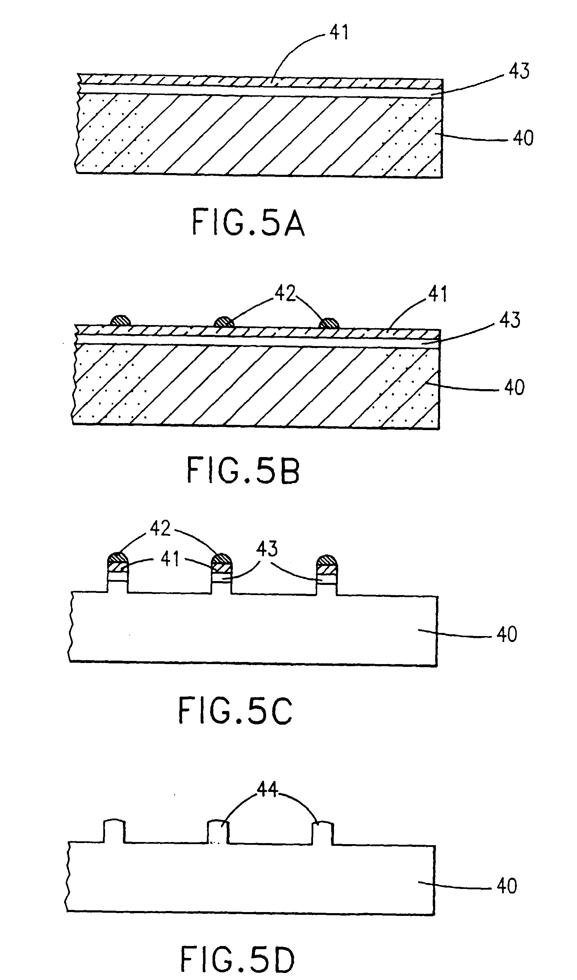

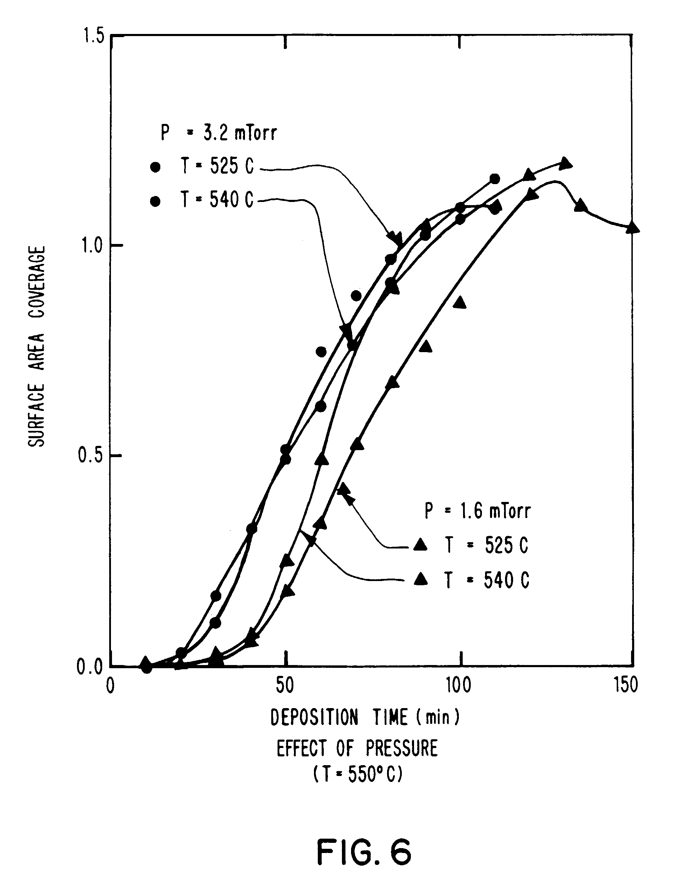

Another application is shown in Figures 5(a) through 5(d), namely the formation of Si quantum dots for light emitting structures, for which the process sequence consists of the following steps:
1. An oxide layer 41 about 200 Å thick is deposited onto the surface of a substrate 40 to form the structure shown in Figure 5(a).
   This oxide can be thermally grown if the substrate material is silicon. For other substrate materials, the oxide layer can be deposited by chemical vapor deposition on top of the substrate. If a material other than oxide is necessary to mask the substrate during the subsequent etching steps described below, a layer 43 of such a material can be deposited underneath the oxide layer 41.
2. Submicrometer dots 42 formed by silicon nuclei are deposited, by chemical vapor deposition using silane gas, on the surface of the oxide layer 41 to form the structure shown in Figure 5(b).
   A given set of deposition parameters (temperature and pressure) will be chosen in order to obtain a desired nuclei density and nuclei size, respectively. For example, Figure 6 is a plot of surface area coverage by grown nuclei as a function of deposition time at a temperature of 550 °C for deposition pressures of 1.6 and 3.2 mTorr (0.21 - 0.43 Pa). It will be seen from this data and that of Figure 4 that the area coverage of silicon on the surface, and therefore the Si dot size, can be controlled by suitable adjustments in temperature and pressure.
   It may be advantageous in this regard to deposit silicon nitride instead of silicon oxide. The nuclei density and growth rate of the nitride nuclei will be different from an oxide surface and should be determined. In addition, the substrate surface can be treated in-situ before the deposition of the nuclei, for example, by carbon exposure or by locally etching certain areas of the oxide surface, in order to control the location of these nuclei centers and/or to further modify the nuclei density.
3. The pattern of silicon dots 42 can be transferred onto the underlying oxide layer 41 by selectively reactive ion etching (RIE) the unexposed oxide, using the silicon nuclei as a mask. The same pattern can then be transferred into the substrate 40 with another reactive ion etching step by using the oxide pattern as a mask and changing the etching gas composition, resulting in the configuration shown in Figure 5(c).
   As indicated above, if a material, other than oxide, is necessary to mask the substrate material 40 during the etching steps, a layer 43 of such a material can be deposited, and such an interlayer etch stop material may be used below the SiO₂ layer to maintain the dot pattern, after selective removal of the SiO₂ between the Si dots, and then to transfer the dot pattern into the Si substrate.
4. Finally, the remaining oxide and silicon nuclei are etched away leaving the nanometer-size Si dot (44) structure shown in Figure 5(d).

### Summary considerations

The low pressure conditions needed for this invention are readily achievable in ultrahigh-vacuum (UHV) CVD reactors suited for low temperature epitaxy (typically batch reactors), as well as in UHV/CVD single-wafer rapid thermal CVD reactors. Reactors of both types are available commercially and may be selected as appropriate by those of skill in the art.

Results were obtained as the result of work carried out in the latter-type reactor, and demonstrated the growth of rough Si surfaces over a broad temperature range (∼100°C), with controllable nuclei density (grain size) and nuclei shape. Apparent roughness enhancement of at least 2-3X has been demonstrated for growth on both thin thermal (device) oxide surfaces and on surfaces with only a very thin chemical oxide (prepared by standard wet cleaning procedures). Finally, it has also been demonstrated that rough Si surfaces can be grown using batch hot-wall UHV/CVD reactors. Since up to 50-100 wafers can be simultaneously processed in this way, this process opens the door to high throughput manufacturing.

As Si CVD growth typically exhibits some selectivity, it is clear that a variety of Si-containing reactants can be used for deposition, such as disilane, dichlorosilane, etc. Furthermore, it is contemplated that other surface insulators could be employed directly, such as aluminum oxide or a variety of glass materials. If desired, the bulk substrate and insulating nucleation surface materials may be different, e.g., the process could be begun with a bulk glass substrate, on which a thin SiO₂ film is deposited, and the rough Si may then be nucleated on the SiO₂.

It will be seen that the present invention offers significant advantages as compared with the prior art in the fabrication of rough Si surfaces. As noted above, the mechanism differs substantially from that which exploits growth at the amorphous/crystalline transition temperature, where serious manufacturability concerns are raised by the necessity of working with ≤10°C process window.

Another known path to producing rough Si is to employ thermal oxidation of polySi, which is considerably faster at doped grain boundaries than into the grains. However, this approach appears to have achieved only 1.34X area enhancement so far (See, P. C. FAZAN AND A. DITALI, "Electrical characterization of textured interpoly capacitors for advanced stacked DRAMs", IEDM 90-663, 27.5.1, 1990. (Micron Technol. Corp.)). Also, relatively high temperatures are required for thermal oxidation, and lower thermal budgets which maintain amorphous Si structure are not usable, as the thermal oxidation will inevitably cause Si grain growth, leading to large-grain structures.

Another alternative is to use plasma generation of particles to form a roughness template and then to transfer that roughness pattern into the surface by anisotropic selective etching, e.g., RIE (see IBM TDB of G. S. SELWYN ET AL cited above). However, this approach is limited to rough Si formation only on top surfaces due to plasma directionality. This prevents deposition of rough Si on sidewalls, making it unusable for current DRAM designs which always exploit extensive sidewall area in either stacked or trench capacitor geometries.

## Claims

1. A method for fabricating surface textures with random, nanometer-scale roughness comprising the steps of:
providing a substrate having a surface
depositing Si nuclei on said surface and controlling the density and size of said Si nuclei formed on said surface by regulating the temperature and pressure conditions of said deposition;
selectively growing Si on distinct nucleation sites for enhancing and transferring the morphology pattern of the nucleation sites into a thicker, rough Si surface texture, wherein said deposition is at a pressure in the range from 0.1 mTorr to 100 mTorr (0.013 Pa - 13.3 Pa).

2. A method for fabricating surface textures with random, nanometer-scale roughness comprising the steps of:
providing a substrate having a surface conditioned so that it is substantially inert with respect to reaction with Si-containing species;
depositing Si nuclei on said surface and controlling the density and size of said Si nuclei formed on said surface by regulating the temperature and pressure conditions of said deposition;
selectively growing Si on distinct nucleation sites for enhancing and transferring the morphology pattern of the nucleation sites into a thicker, rough Si surface texture, wherein said deposition is at a temperature in the range from 450°C to 700°C.

3. The method of claim 1 wherein said surface is conditioned so that it is substantially inert with respect to reaction with Si-containing species within a temperature range from 450°C to 700°C.

4. The method of claim 1 or 2 wherein the step of providing a substrate comprises forming an oxide layer on the surface of said substrate.

5. The method of claim 1 or 2 wherein said surface is conditioned by the deposition of impurities from at least one of gas phase exposure, liquid exposure, and physical vapor deposition, or
wherein said surface is conditioned by the creation of defects therein by at least one of ion implantation, x-ray radiation, ion etching/bombardment, and UV light to break surface bonds, or
wherein said surface is conditioned by the chemical modification of the surface by the growth of incomplete or defective layers thereon, or
wherein said surface is conditioned by the growth of a full surface layer comprising at least one of a native oxide, thermal oxide, CVD nitride, and plasma-enhanced CVD (PECVD) dielectric.

6. The method of any of the claims 1 to 5 further comprising the step of producing a thin conformal dielectric layer over said rough Si surface.

7. The method of claim 6, further comprising the step of depositing a Si top electrode over said dielectric layer.

8. The method of any of the claims 1 to 5, further comprising the step of conformally depositing a layer of magnetic material on said silicon substrate to produce a low-stiction thin magnetic disk surface on said substrate.

9. The method of any of the claims 1 to 8 wherein said deposition is done by ultra-high-vacuum chemical-vapor-deposition (UHV-CVD).

10. The method of any of the claims 3 to 9 wherein said deposition is at a pressure in the range from 1 to 5 mTorr (0.13 - 0.67 Pa) and at a temperature in the range of 500 - 600°C.

## Patentansprüche

1. Verfahren zur Herstellung von Oberflächentexturen mit zufälliger Rauhigkeit im Nanometerbereich, das die Schritte umfaßt:
Bereitstellen eines Substrates mit einer Oberfläche;
Aufbringen von Si-Nukleationskeimen auf der Oberfläche und Steuern der Dichte und Größe der auf der Oberfläche ausgebildeten Si-Nukleationskeime durch Regeln der Temperatur- und Druckbedingungen der Deposition;
selektives Aufwachsen von Si auf bestimmte Nukleationsstellen, um die Morphologiestruktur der Nukleationsstellen in eine dickere, rauhe Si-Oberflächentextur zu steigern und zu transferieren, wobei die Deposition bei einem Druck im Bereich von 0,1 mTorr bis 100 mTorr (0,013 Pa bis 13,3 Pa) stattfindet.

2. Verfahren zur Herstellung von Oberflächentexturen mit zufälliger Rauhigkeit im Nanometerbereich, das die Schritte umfaßt:
Bereitstellen eines Substrates mit einer Oberfläche, die derart konditioniert ist, daß sie bezüglich einer Reaktion mit Si-haltigen Spezies im wesentlichen inert ist;
Aufbringen von Si-Nukleationskeimen auf der Oberfläche und Steuern der Dichte und Größe der auf der Oberfläche ausgebildeten Si-Nukleationskeime durch Regeln der Temperatur- und Druckbedingungen der Deposition;
selektives Aufwachsen von Si auf bestimmte Nukleationsstellen, um die Morphologiestruktur der Nukleationsstellen in eine dickere, rauhe Si-Oberflächentextur zu steigern und zu transferieren, wobei die Deposition bei einer Temperatur im Bereich von 450° C bis 700° C stattfindet.

3. Verfahren nach Anspruch 1, wobei die Oberfläche derart konditioniert ist, daß sie bezüglich einer Reaktion mit Si-haltigen Spezies innerhalb eines Temperaturbereichs von 450° C bis 700° C im wesentlichen inert ist.

4. Verfahren nach Anspruch 1 oder 2, wobei der Schritt der Bereitstellung eines Substrates das Bilden einer Oxidschicht auf der Oberfläche des Substrates beinhaltet.

5. Verfahren nach Anspruch 1 oder 2, wobei die Oberfläche durch die Deposition von Fremdatomen aus wenigstens einer der Techniken Gasphaseneinwirkung, Flüssigkeitseinwirkung und physikalische Gasphasenabscheidung konditioniert wird, oder
wobei die Oberfläche durch die Erzeugung von Defekten in derselben durch wenigstens eine der Techniken Ionenimplantation, Röntgenstrahleneinwirkung, Ionenätzen/-beschuß und UV-Licht konditioniert wird, um Oberflächenbindungen zu brechen, oder
wobei die Oberfläche durch die chemische Modifikation der Oberfläche durch das Aufwachsen von unvollständigen oder defektbehafteten Schichten darauf konditioniert wird, oder
wobei die Oberfläche durch das Aufwachsen einer vollständigen Oberflächenschicht konditioniert wird, die wenigstens eines von einem natürlichen Oxid, thermischen Oxid, CVD-Nitrid und plasmaunterstützten CVD(PECVD)-Dielektrikum beinhaltet.

6. Verfahren nach irgendeinem der Ansprüche 1 bis 5, das des weiteren den Schritt der Erzeugung einer dünnen konformen dielektrischen Schicht über der rauhen Si-Oberfläche umfaßt.

7. Verfahren nach Anspruch 6, das des weiteren den Schritt des Aufbringens einer oberen Elektrode aus Si über der dielektrischen Schicht umfaßt.

8. Verfahren nach irgendeinem der Ansprüche 1 bis 5, das des weiteren den Schritt des konformen Aufbringens einer Schicht aus magnetischem Material auf dem Siliciumsubstrat umfaßt, um eine dünne magnetische Plattenoberfläche mit geringer Haftreibung auf dem Substrat zu erzeugen.

9. Verfahren nach irgendeinem der Ansprüche 1 bis 8, wobei die Deposition durch chemische Gasphasenabscheidung im Ultrahochvakuum (UHV-CVD) erfolgt.

10. Verfahren nach irgendeinem der Ansprüche 3 bis 9, wobei die Deposition bei einem Druck im Bereich von 1 mTorr bis 5 mTorr (0,13 Pa bis 0,67 Pa) und bei einer Temperatur im Bereich von 500° C bis 600° C stattfindet.

## Revendications

1. Procédé de fabrication de textures de surface présentant une rugosité aléatoire, à l'échelle nanométrique, comprenant les étapes consistant à :
produire un substrat ayant une surface
déposer des noyaux de Si sur lesdites surfaces et réguler la densité et la feuille desdits noyaux de Si formés sur ladite surface, en régulant la température et les conditions de température et de pression de ladite déposition;
produire une croissance sélective de Si sur des sites de nucléation distincts, afin d'améliorer et de transférer le motif morphologique des sites de nucléation pour donner une texture de surface de Si plus épaisse, rugueuse, dans lequel ladite déposition se fait à une pression de l'ordre de 0,1 mTorr à 100 mTorr (0,013 Pa à 13,3 Pa).

2. Procédure de fabrication de textiles de surface ayant une rugosité aléatoire à l'échelle nanométrique, comprenant les étapes consistant à :
produire un substrat, ayant une surface conditionnée de manière à ce qu'elle soit sensiblement inerte par rapport à la réaction avec des espèces contenant du Si;
déposer des noyaux de Si sur ladite surface et réguler la densité et la taille desdits noyaux de Si formés sur ladite surface, en régulant les conditions de température et de pression de ladite déposition;
produire une croissance sélective de Si sur des sites de nucléation distincts, pour améliorer et transférer le motif morphologique des sites de nucléation, en donnant une texture de surface Si plus épaisse, rugueuse, dans lequel ladite déposition se fait à une température comprise dans la plage allant de 450°C à 700°C.

3. Le procédé selon la revendication 1, dans lequel ladite surface est conditionnée de manière à être sensiblement inerte par rapport à la réaction avec des espèces contenant Si dans une plage de température allant de 450°C à 700°C.

4. Le procédé selon la revendication 1 ou 2, dans lequel l'étape de production d'un substrat comprend la formation d'une couche d'oxyde sur la surface dudit substrat.

5. Le procédé selon la revendication 1 ou 2, dans lequel ladite surface est conditionnée par la déposition d'impuretés à partir d'au moins une procédure parmi l'exposition à une phase gazeuse, une exposition à un liquide et une déposition physique en phase vapeur, ou
dans lequel ladite surface est conditionnée par la création en son sein de défauts, par au moins un procédé parmi l'implantation d'ions, une irradiation aux rayons X, une morsure/bombardement par ions et une exposition à la lumière UV pour rompre les liaisons de surface, ou
dans lequel ladite surface est conditionnée par la modification chimique de la surface, par croissance sur elle de couche incomplètes ou défectueuses, ou
dans lequel ladite surface est conditionnée par la croissance d'une couche de surface complète, comprenant au moins un élément parmi un oxyde natif, un oxyde obtenu par voie thermique, un nitrure obtenu par CVD et un diélectrique obtenu par CVD (PECVD) amélioré au plasma.

6. Le procédé selon l'une quelconque des revendications 1 à 5, comprenant en outre l'étape consistant à produire une couche diélectrique à conformation mince sur ladite surface Si rugueuse.

7. Le procédé selon la revendication 6, comprenant en outre l'étape de déposition d'une électrode supérieure en Si sur ladite couche diélectrique.

8. Le procédé selon l'une quelconque des revendications 1 à 5, comprenant en outre l'étape de déposition conforme d'une couche de matériau magnétique sur ledit substrat en silicium, afin de produire une surface de disque magnétique mince à faible frottement statique sur ledit substrat.

9. Le procédé selon l'une quelconque des revendications 1 à 8, dans lequel ladite déposition est faite par une déposition en phase vapeur chimique, sous vide, ultra haut (UHV-CVD).

10. Le procédé selon l'une quelconque des revendications 3 à 9, dans lequel ladite déposition se fait à une pression comprise dans la plage de 1 à 5 mTorr (0,13 à 0,67 Pa) et à une température dans la plage de 500 à 600°C.
